(19) Europäisches Patentamt

European Patent Office

Office européen des brevets

(11) **EP 1 056 198 B1**

(12) **EUROPÄISCHE PATENTSCHRIFT**

(45) Veröffentlichungstag und Bekanntmachung des Hinweises auf die Patenterteilung:
**27.04.2005   Patentblatt 2005/17**

(51) Int Cl.⁷: **H03G 3/30**, H04B 7/26

(21) Anmeldenummer: **00109851.6**

(22) Anmeldetag: **10.05.2000**

(54) **Schaltungsanordnung und Verfahren zum adaptiven Regeln der Verstärkung eines rückgekoppelten Verstärkers**

Circuitry and Method of Adaptive Control of the Gain of a Feedback Amplifier

Circuit et méthode de commande adaptative de gain d'un amplificateur à rétroaction

(84) Benannte Vertragsstaaten:
**AT BE CH CY DE DK ES FI FR GB GR IE IT LI LU MC NL PT SE**

(30) Priorität: **25.05.1999   DE 19923790**

(43) Veröffentlichungstag der Anmeldung:
**29.11.2000   Patentblatt 2000/48**

(73) Patentinhaber: **Deutsche Telekom AG**
**53113 Bonn (DE)**

(72) Erfinder:
• **Lorenz, Rudolf Werner, Dr.**
**64401 Gross-Bieberau (DE)**

• **Dannowski, Klaus, Dr.**
**01217 Dresden (DE)**
• **Freiburger, Georg, Dr.**
**01067 Dresden (DE)**
• **Rau, Armin, Dr.**
**01307 Dresden (DE)**

(56) Entgegenhaltungen:
**EP-A- 0 149 152           EP-A- 0 772 310**
**DE-A- 19 752 283          US-A- 4 776 032**
**US-A- 5 736 901**

**Beschreibung**

Die Erfindung betrifft eine Schaltungsanordnung sowie ein Verfahren zum adaptiven Regeln der Verstärkung eines rückgekoppelten Verstärkers für digitale Signale. Sie ist eine weitere Ausführungsform zu der Patentanmeldung DE-A-197 52 283.

In jüngster Zeit werden digitale terrestrische Rundfunksyteme, wie z. B.das DAB (Digital Audio Broadcasting)-T- oder das DVB (Digital Video Broadcasting)-T-System, in Gleichwellennetzen betrieben, bei denen von mehreren Standorten aus synchron gesendet wird. Zur Füllung von Versorgungslücken werden Repeaterverstärker eingesetzt, deren Sende- und Empfangsantennen aufgrund einer Strahlungskopplung parasitär rückgekoppelt sind. Wenn die Verstärkung eines Repeaterverstärkers die Entkopplungsdämpfung zwischen dessen Sende- und Empfangsantenne erreicht, gerät dieser in Schwingung. Um Schwingungen und damit einen instabilen Betrieb zu vermeiden, muß die Verstärkung um einen Sicherheitsabstand kleiner sein als die Entkopplungsdämpfung. Unter dem Sicherheitsabstand versteht man ganz allgemein die in dB gemessene Differenz zwischen der Entkopplungsdämpfung zwischen dem Ein- und Ausgang eines Verstärkers und dessen Verstärkungsfaktor. Da die Strahlungskopplung zwischen der Sende- und Empfangsantenne des Repeaterverstärkers durch Umgebungseinflüsse, wie z. B. durch vor einer Antenne fliegende Objekte (Flugzeuge, Vögel, Schnee u.s.w.) oder durch zeitweise auf der Antenne befindlichen Objekte, zeitvariant sein kann, kann die Entkopplungsdämpfung zeitweise derart verkleinert sein, daß der Repeaterverstärker in Schwingung gerät. Um einen stabilen Betrieb zu gewährleisten, sind bisher bekannte, geregelte Verstärker oder Repeater-Verstärker derart ausgebildet, daß deren Verstärkung statisch um einen erheblichen Sicherheitsabstand, beispielsweise um 15 dB, unter einer gemessenen mittleren Entkopplungsdämpfung eingestellt wird. Die mittlere Entkopplungsdämpfung ergibt sich im wesentlichen aus systembedingten Eigenschaften, wie z.B. der Orientierung der Sende- und Empfangsantenne, dem Abstand der Antennen zueinander und der höhenversetzten Montage der Sende- und Empfangsantennen. Obwohl bei den bekannten Repeatern der Sicherheitsabstand recht groß gewählt ist, kann es trotzdem zur Selbsterregung des Repeaterverstärkers kommen, wenn sich die Entkopplungsdämpfung zeitweise oder dauerhaft drastisch verringert. Eine Herabsetzung des Sicherheitsabstandes tritt auch ein, wenn der Signalpegel am Repeater-Ausgang abnimmt, weil dann bei der üblichen Regelung der Ausgangsleistung die Verstärkung ansteigt, um dem Absinken der Ausgangsleistung entgegenzuwirken. Bei den herkömmlichen Repeater-Verstärkern, deren Verstärkung unabhängig von der aktuellen Entkopplungsdämpfung eingestellt wird, ist es ferner sehr schwierig festzustellen, ob der Sicherheitsabstand bezüglich des Schwingeinsatzpunktes mit viel zu großer Reserve eingestellt worden ist und dadurch Versorgungsreichweite und -qualität verschenkt wird, wodurch der Repeater unwirtschaftlich betrieben wird.

Die Druckschrift DE 34 01 748 A1 betrifft eine Schaltungsanordnung für eine digitale Pegelregelung mit einem in seiner Verstärkung einstellbaren Regelverstärker, der von einem Regler her für eine stufenweise Veränderung seines Ausgangspegels in vorgegebenen Zeitabständen Stellsignale zugeführt erhält, einem Pegeldiskriminator, der bei einer Abweichung des von dem Regelverstärker als Regelgröße abgegebenen Pegels von einem Sollpegel ein die Richtung der Regelabweichung anzeigendes Signal als Stellgröße an den Regler abgibt und zusätzlich den Betrag der Regelabweichung ermittelt, sowie mit einem Taktgenerator. Der Regler legt abhängig von diesem Betrag der Regelabweichung die Zeitabstände fest, in denen die Stellsignale an den Regelverstärker abgegeben werden.

Die Erfindung basiert auf einer weiteren Ausführungsform zu der Patentanmeldung DE-A-197 52 283.

Der Kerngedanke der Erfindung ist darin zu sehen, den Arbeitspunkt des Verstärkers derart zu verschieben, daß ein voreingestellter Schwingabstand des rückgekoppelten Verstärkers zum Schwingeinsatzpunkt gewährleistet ist. In der Beschreibung und in den Ansprüchen wird als Schwingabstand der Abstand zwischen der Verstärkung $V_0$ der im Verstärker enthaltenden Verstärkerstufen und der Verstärkung $V_S$ , bei der der Verstärker in Schwingung geraten würde, verstanden. Dieser Ansatzpunkt ergibt sich aus der Tatsache, daß der Schwingabstand des Verstärkers ein eindeutiges Maß für die Stärke der sich in dem Verstärker einstellenden Mitkopplung ist. Bekanntlich nimmt die durch die Mitkopplung mitbestimmte resultierende Verstärkung V mit stärker werdender Mitkopplung aufgrund einer Verstärkungsanfachung gemäß der Gleichung

$$V = V_0/(1-kV_0) \qquad (1)$$

zu, wobei $V_0$ die Verstärkung des regelbaren Verstärkers und k die Rückkopplung des Verstärkers ist. Beim Schwingabstand 0 ist die resultierende Verstärkung V schließlich unendlich groß,- so daß der Verstärker auch ohne ein anliegendes Eingangssignal ein Ausgangssignal abgibt, also schwingt. Ferner hat sich gezeigt, daß die Änderung der resultierenden Verstärkung V, die beim Ändern des Schwingabstandes um einen bestimmten Betrag entsteht, diesen Betrag der Schwingabstandänderung um so mehr übertrifft, je geringer der Schwingabstand selbst ist.

Das technische Problem löst die Erfindung zum einen mit den Merkmalen des Anspruchs 1.

Um einen vorgegebenen Sicherheitsabstand eines rückgekoppelten Verstärkers von dessen zeitlich schwankenden Schwingeinsatzpunktes gewährleisten zu können, ist die in der Schaltungsanordnung nach der Patentanmeldung DE-A-197 52 283 eingesetzte Überwachungs- und Auswerteeinrichtung zum Überwachen und Auswerten einer Änderung des Signalpegels am Ausgang des Verstärkers ausgebildet. Ferner ist eine Einrichtung zum periodischen Ändern, insbesondere zum Absenken einer vorbestimmten Verstärkung ($V_0$) des Verstärkers um einen ersten vorbestimmten Betrag in vorbestimmten zeitlichen Abständen für jeweils eine vorbestimmte Zeitdauer vorgesehen. Zudem ist eine Einrichtung zum Anheben oder Absenken der vorbestimmten Verstärkung $V_0$ um einen zweiten vorbestimmten Betrag in Abhängigkeit der beim periodischen Ändern der vorbestimmten Verstärkung ausgewerteten Änderung des Signalpegels am Verstärkerausgang vorgesehen. Auf diese Weise erfolgt die Verschiebung des Ärbeitspunktes des rückgekoppelten Verstärkers.

Vorteilhafte Weiterbildungen sind Gegenstand der Unteransprüche.

Um zu verhindern, daß der Verstärker in Schwingung versetzt wird, darf der Abstand zwischen der geregelten Verstärkung $V_0$ der im Verstärker enthaltenen Verstärkerstufen und der Verstärkung $V_S$, bei der es in dem Verstärker zum Einsetzen von Schwingungen kommen würde, nicht unterschritten werden. Hierzu weist die Schaltungsanordnung einen Speicher auf, in dem ein vorbestimmter Schwingabstand, der durch das Verhältnis $V_S/V_0$ definiert wird, abgelegt ist. Ferner ist die Überwachungs- und Auswerteeinrichtung derart ausgebildet, daß sie aus der Änderung des Signalpegels am Verstärkerausgang in Abhängigkeit von der Änderung der vorbestimmten Verstärkung um den ersten vorbestimmten Betrag den aktuellen Schwingabstand des Verstärkers ermitteln und diesen mit dem gespeicherten Schwingabstand vergleichen kann. Wenn der vorbestimmte Schwingabstand unterschritten wird, wird die vorbestimmte Verstärkung $V_0$ um den zweiten vorbestimmten Betrag abgesenkt. Wenn hingegen der aktuell ermittelte Schwingabstand größer als der gespeicherte Schwingabstand ist, wird die Verstärkung $V_0$ des Verstärkers um den zweiten vorbestimmten Betrag angehoben.

Besonders vorteilhaft ist es, wenn die Einrichtung zum periodischen Ändern ein Dämpfungselement zum periodischen Absenken der vorbestimmten Verstärkung enthält. Denn mit dem Absenken der vorbestimmten Verstärkung des Verstärkers um den ersten vorbestimmten Betrag wird der Schwingabstand bereits während der Überwachungs- und Auswertephase vorübergehend vergrößert, wodurch die Selbsterregungsgefahr des Verstärkers während dieser Zeitspanne verringert werden kann.

Die Weiterbildung der Patentanmeldung 197 52 283 wird ebenfalls durch die Verfahrensschritte des Anspruchs 4 definiert.

Danach wird zunächst die Verstärkung $V_0$ des Verstärkers voreingestellt. Anschließend wird die voreingestellte Verstärkung $V_0$ um einen ersten vorbestimmten Betrag periodisch geändert. Während der periodischen Änderung der voreingestellten Verstärkung wird eine Änderung des Signalpegels am Verstärkerausgang überwacht und ausgewertet. In Abhängigkeit von der während der periodischen Änderung der vorbestimmten Verstärkung ausgewerteten Änderung des Signalpegels am Verstärkerausgang wird die voreingestellte Verstärkung um einen zweiten vorbestimmten Betrag angehoben oder abgesenkt. Dieses Anheben oder Absenken der voreingestellten Verstärkung entspricht einem Anheben oder Absenken des Arbeitspunktes des Verstärkers.

Vorteilhafte Weiterbildungen sind in den Unteransprüchen umschrieben.

Das Maß der Mitkopplung des rückgekoppelten Verstärkers kann dadurch ermittelt werden, daß aus der Änderung des Signalpegels am Verstärkerausgang die Verstärkungsänderung des rückgekoppelten Verstärkers ermittelt wird. Aus der periodischen Änderung der voreingestellten Verstärkung $V_0$ um den ersten vorbestimmten Betrag und der daraus resultierenden Verstärkungsänderung des Verstärkers wird der aktuelle Schwingabstand des Verstärkers berechnet. Anschließend wird der aktuelle Schwingabstand mit einem vorbestimmten, in einem Speicher abgelegten Schwingabstand verglichen.

Wie bereits erwähnt, kann die periodische Änderung der voreingestellten Verstärkung um einen ersten vorbestimmten Betrag durch ein periodisches Absenken erfolgen.

Die Erfindung wird nachfolgend anhand eines Ausführungsbeispiels in Verbindung mit den beiliegenden Zeichnungen näher erläutert. Darin zeigen:

Fig. 1    ein Blockschaltbild eines adaptiven Repeaters gemäß der Erfindung, und

Fig. 2    ein Diagramm, bei dem die resultierende Verstärkung des Verstärkers 10 nach Fig. 1 über der Verstärkung der regelbaren Verstärkerstufe 20 aufgetragen ist.

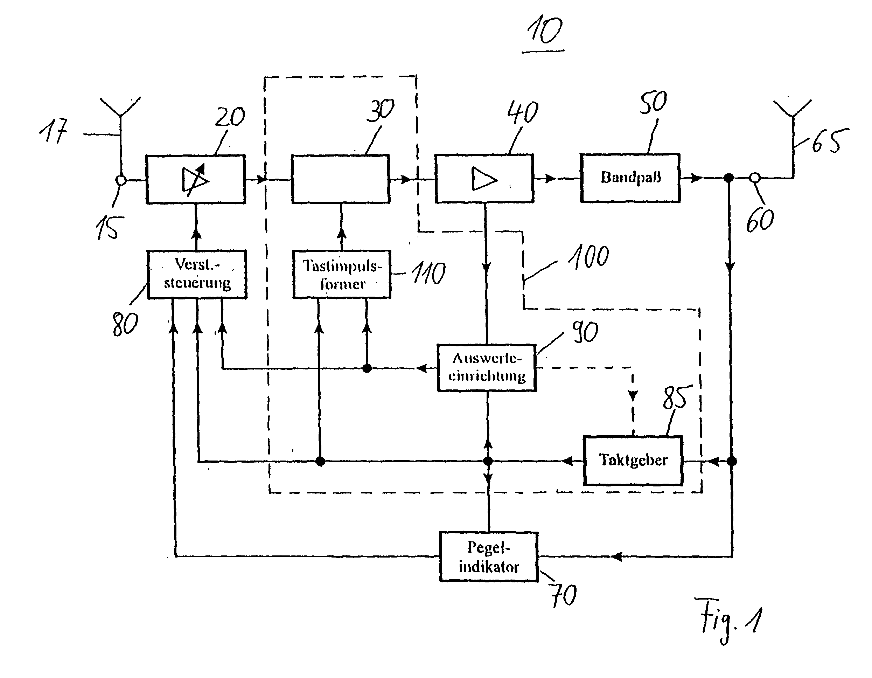

Fig. 1 zeigt die Prinzipschaltung eines adaptiven Verstärkers, der beispielsweise in einem digitalen terrestrischen Rundfunksystem zur Auffrischung von digitalen Signalen verwendbar ist. Der allgemein mit 10 bezeichnete adaptive Verstärker umfaßt einen Signaleingang 15, an dem eine Empfangsantenne 17 angeschlossen ist. Die Empfangsantenne 17 ist mit einer regelbaren Verstärkerstufe 20 verbunden, die an sich bekannt ist. In an sich bekannter Weise enthält der Verstärker 10 weiter eine als Leistungsverstärker aufgebaute Endstufe 40 , ein Bandpaßfilter 50, einen Signalausgang 60 sowie eine daran angeschaltete Sendeantenne 65. Gewöhnlich ist ein Pegelindikator 70 eingangsseitig mit dem Signalausgang 60 verbunden, wobei dessen Ausgang über eine an sich bekannte Verstärkungs-Steuerungseinrichtung 80 mit der regelbaren Verstärkerstufe 20 verbunden ist. Ein über einen Tastimpulsformner 110 ansteuerbares Dämpfungselement 30 ist eingangsseitig mit der regelbaren Verstärkerstufe 20 und ausgangsseitig mit der Endstufe 40 verbunden. Wie nachfolgend noch näher ausgeführt wird, hat das Dämpfungselement die Aufgabe, die voreingestellte Verstärkung $V_0$ der regelbaren Verstärkerstufe 20 um einen ersten vorbestimmten Betrag in vorbestimmten zeitlichen Abständen für jeweils eine vorbestimmte Zeitdauer abzusenken. Ferner ist ein Taktgeber 85 vorgesehen, der eingangsseitig mit dem Signalausgang 40 verbunden sein kann. Eine Überwachungs- und Auswerteeinrichtung 90 ist beispielsweise mit dem Ausgang der Endstufe 40 verbunden. Darüber hinaus ist der Ausgang der Überwachungs- und Auswerteeinrichtung 90 mit einem Eingang des Tastimpulsformers 110 verbunden. Der Tastimpulsformer 110 ist ausgangsseitig wiederum mit dem Dämpfungselement 30 und der Verstärkungs-Steuerungseinrichtung 80 verbunden. Die Überwachungs- und Auswerteeinrichtung 90 ist ferner mit einem Eingang der Verstärkungs-Steuerungseinrichtung 80 und fakultativ mit einem Eingang des Taktgebers 85 verbunden.

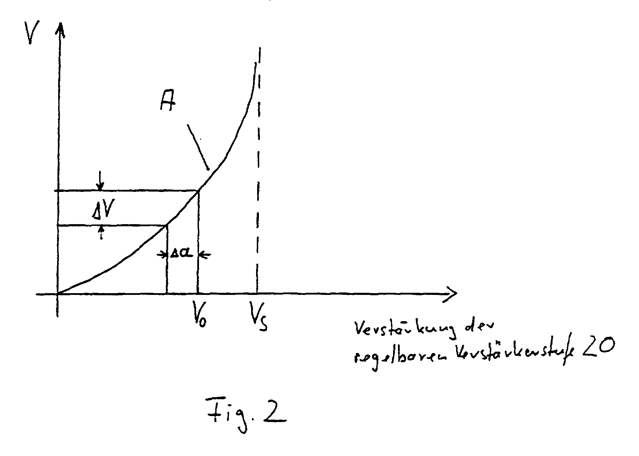

Die Funktionsweise der Schaltungsanordnung wird nachfolgend in Verbindung mit Fig. 2 ausführlicher geschildert.

Zunächst wird in der oben angegebenen Gleichung (1) die Rückkopplung k durch den Ausdruck $1/V_S$ ersetzt, wobei mit $V_S$ die Verstärkung bezeichnet wird, bei der der Verstärker 10 zu Schwingen beginnt. Daraus folgt

$$v = V_0/(1-V_0/V_S), \qquad (2)$$

wobei $V_S/V_0$ der oben definierte Schwingabstand des Verstärkers ist.

In Fig. 2 ist eine Verstärkungskurve A des rückgekoppelten verstärkers 10 gemäß Gleichung (2) dargestellt, wobei die resultierende Verstärkung V des rückgekoppelten Verstärkers 10 über der Verstärkung der regelbaren Verstärkerstufe 20 des Verstärkers ist. Ferner ist der an der regelbaren Verstärkerstufe 20 voreingestellte Arbeitspunkt des Verstärkers 10 eingezeichnet, der bei der Verstärkung $V_0$ liegt. Die kritische Verstärkung $V_S$, bei der der Verstärker 10 in Schwingung gerät, bildet die senkrechte Asymptote für die Kurve A.

Wie bereits erwähnt, wird der zeitvariante Schwingabstand des Verstärkers 10 periodisch überwacht und ausgewertet, um den vorbestimmten Sicherheitsabstand $V_S/V_0$ zum Schwingeinsatzpunkt $V_S$ gewährleisten-zu können. Hierzu wird die Verstärkung $V_0$ der regelbaren Verstärkerstufe 20 um einen ersten vorbestimmten Betrag $\Delta a$ abgesenkt, indem mit Hilfe des Tastimpulses des Tastimpulsformers 110 in vorbestimmten zeitlichen Abständen für jeweils eine vorbestimmte Zeitdauer das Dämpfungselement aktiviert

wird. Der Betrag $\Delta a$ ist in dem Diagramm nach Fig. 2 eingetragen. Infolge des Absenkens des Arbeitspunktes ändert sich am Ausgang 60 des Verstärkers 10 der Signalpegel, dessen Änderung ein Pegelindikator 70, der ausgangsseitig mit der Überwachungs- und Auswerteeinrichtung 90, der Vertärkungs-Steuereinrichtung 80 und dem Tastimplulsformer 110 verbunden sein kann, feststellt. Für die Pegelmessung im Pegelindikator 70 stehen logarithmierend wirkende integrierte Schältungslösungen zur Verfügung. Die Umsetzung ihrer Ausgangssignale in Digitalwerte ermöglicht einen günstigen Aufbau des Pegelindikators 70 und der Überwachungs- und Auswerteeinrichtung 90. Aus der Änderung des Signalpegels ermittelt die Überwachungs- und Auswerteeinrichtung 90 die entsprechende Änderung $\Delta v$ der Verstärkung V des rückgekoppelten Verstärkers 10. Aus dem Verhältnis $\Delta a/\Delta v$ kann die Überwachungs- und Auswerteeinrichtung 110 ferner den aktuellen Schwingabstand $V_S/V_0$ des Verstärkers 10 ermitteln. Dazu kann sich die Überwachungs- und Auswerteeinrichtung 90 einer in einem Speicher abgelegten Nachschlagetabelle bedienen, die für jedes gemessenen Verhältnis $\Delta a/\Delta v$ den dazugehörenden Schwingabstand $V_S/V_0$ enthält. Alternativ kann die Überwachungs- und Auswerteeinrichtung zur Ermittlung des aktuellen Schwingabstandes die Gleichung

$$V_S/V_0 = 1/ (1-\Delta a/\Delta V) \qquad (3)$$

anwenden, die sich aus der Steigung der in Fig. 2 dargestellten Kurve A ergibt.

Die Überwachungs- und Auswerteeinrichtung 90 vergleicht nunmehr den ermittelten aktuellen Schwingabstand des Verstärkers 10 mit einem vorher abgespeicherten Schwingabstand. Ist der aktuelle Schwingabstand kleiner als der voreingestellte Schwingabstand, wird die Verstärkung $V_0$ des regelbaren Verstärkers 10 um einen vorbestimmten Betrag abgesenkt, was einer Absenkung des Arbeitspunktes des Verstärkers entspricht. Auf diese Weise wird sichergestellt, daß der voreingestellte Schwingabstand des Verstärkers 10 eingehalten wird. Stellt die Überwachungs- und Auswerteeinrichtung 90 hingegen fest, daß der ermittelte aktuelle Schwingabstand größer als der voreingestellte Schwingabstand ist, dann wird die Verstärkung $V_0$ der regelbaren Verstärkerstufe 20 um einen vorbestimmten Betrag angehoben, was einer Anhebung des Arbeitspunktes des Verstärkers entspricht.

## Patentansprüche

1. Schaltungsanordnung zum adaptiven Regeln der Verstärkung eines rückgekoppelten Verstärkers für digitale Signale mit einem Taktgeber (85), und einer Überwachungs- und Auswerteeinrichtung (90),
**dadurch gekennzeichnet, daß**
die Überwachungs- und Auswerteeinrichtung zum Überwachen und Auswerten einer Änderung des Signalpegels am Verstärkerausgang ausgebildet ist, daß
eine Einrichtung (100) zum periodischen Ändern einer vorbestimmten Verstärkung ($V_0$) des Verstärkers um einen ersten vorbestimmten Betrag ($\Delta a$) in vorbestimmten zeitlichen Abständen für jeweils eine vorbestimmte Zeitdauer und
eine Einrichtung (20, 80) zum Anheben oder Absenken der vorbestimmten Verstärkung ($V_0$) um einen zweiten vorbestimmten Betrag in Abhängigkeit der beim periodischen Ändern der vorbestimmten Verstärkung ausgewerteten Änderung des Signalpegels am Verstärkerausgang vorgesehen ist.

2. Schaltungsanordnung nach Anspruch 1,
**dadurch gekennzeichnet, daß**
ein Speicher, der einen vorbestimmten Schwingabstand des Verstärkers speichert, mit der Überwachungs- und
Auswerteeinrichtung (90) verbunden-ist, und daß die Überwachungs- und Auswerteeinrichtung aus der Änderung des Signalpegels am Verstärkerausgang in Abhängigkeit von der Änderung der vorbestimmten Verstärkung um den ersten vorbestimmten Betrag den aktuellen Schwingabstand des Verstärkers ermitteln und diesen mit dem gespeicherten Schwingabstand vergleichen kann.

3. Schaltungsanordnung nach Anspruch 1 oder 2,
**dadurch gekennzeichnet, daß**
die Einrichtung zum periodischen Ändern ein Dämpfungselement zum periodischen Absenken der vorbestimmten Verstärkung enthält.

4. Verfahren zum adaptiven Regeln der Verstärkung eines rückgekoppelten Verstärkers für digitale Signale, nach einem der Anspruche 1 bis 3, mit folgenden Verfahrensschritten:

- Voreinstellen der Verstärkung ($V_0$) des Verstärkers;
- periodisches Ändern der voreingestellten Verstärkung ($V_0$) um einen ersten vorbestimmten Betrag ($\Delta a$);
- Überwachen und Auswerten einer Änderung des Signalpegels am Verstärkerausgang während des periodischen Änderns der voreingestellten Verstärkung; und
- Anheben oder Absenken der voreingestellten Verstärkung ($V_0$) um einen zweiten vorbestimmten Betrag in Abhängigkeit von der während des periodischen Änderns der vorbestimmten Verstärkung ausgewerteten Änderung des Signalpegels am Verstärkerausgang.

5. Verfahren nach Anspruch 4,
**dadurch gekennzeichnet, daß**
der Schritt des Überwachens und Auswertens folgende weitere Verfahrensschritte umfasst:

- aus der Änderung des Signalpegels am Verstärkerausgang wird die entsprechende Verstärkungsänderung ( V) des rückgekoppelten Verstarkers ermittelt;
- Berechnen des aktuellen Schwingabstandes des Verstärkers aus der Verstärkungsänderung ($\Delta V$) und der periodischen Änderung der voreingestellten Verstärkung ($V_0$) um einen ersten vorbestimmten Betrag;
- Vergleichen des aktuellen Schwingabstandes mit einem vorbestimmten Schwingabstand.

6. Verfahren nach Anspruch 4 oder 5;
**dadurch gekennzeichnet, daß**

die voreingestellten Verstärkung ($V_0$) um einen ersten vorbestimmten Betrag periodisch abgesenkt wird.

**Claims**

1. Circuit arrangement for the adaptive control of the gain of a feedback amplifier for digital signals with a clock generator (85) and a monitoring and evaluation means (90),
**characterized in that**
the monitoring and evaluation means is formed to monitor and evaluate a change in the signal level at the amplifier output;
a means (100) is provided for periodically changing a predetermined gain ($V_0$) of the amplifier by a first predetermined value ($\Delta a$) at predetermined time intervals each for a predetermined duration and
a means (20, 80) is provided for increasing or reducing the predetermined gain ($V_0$) by a second predetermined value as a function of the change - evaluated during the periodic changing of the predetermined gain - in the signal level at the amplifier output.

2. Circuit arrangement according to claim 1,
**characterized in that**
a storage means, storing a predetermined oscillation interval of the amplifier, is connected to the monitoring and evaluation means (90) and the monitoring and evaluation means is capable - from the change in the signal level at the amplifier output as a function of the change of the predetermined gain by the first predetermined value - of determining the current oscillation interval of the amplifier and comparing same with the stored oscillation interval.

**3.** Circuit arrangement according to claim 1 or 2,
**characterized in that**
the means for periodic change contains an attenuation element for periodically reducing the predetermined gain.

**4.** Method for the adaptive control of the gain of a feedback amplifier for digital signals according to any one of claims 1 to 3, said method having the following method steps:

- presetting of the gain ($V_0$) of the amplifier;
- periodic changing of the preset gain ($V_0$) by a first predetermined value ($\Delta a$);
- monitoring and evaluating of a change in the signal level at the amplifier output during the periodic changing of the preset gain; and
- increasing or reducing of the preset gain ($V_0$) by a second predetermined value as a function of the change - evaluated during the periodic changing of the predetermined gain - in the signal level at the amplifier output.

**5.** Method according to claim 4,
**characterized in that**
the monitoring and evaluating step includes the following further method steps:

- the corresponding change in gain ($\Delta V$) of the feedback amplifier is determined from the change in the signal level at the amplifier output;
- calculation of the current oscillation interval of the amplifier from the change in gain ($\Delta V$) and the periodic changing of the preset gain ($V_0$) by a first predetermined value;
- comparing of the current oscillation interval with a predetermined oscillation interval.

**6.** Method according to claim 4 or 5,
**characterized in that**
the preset gain ($V_0$) is periodically reduced by a first predetermined value.

**Revendications**

**1.** Montage de circuits destiné à la régulation adaptative de l'amplification d'un amplificateur à réaction pour des signaux numériques avec une horloge (85) et un dispositif de contrôle et d'analyse (90),
**caractérisé en ce que**
le dispositif de contrôle et d'analyse est configuré pour le contrôle et l'analyse d'une modification du niveau des signaux à la sortie de l'amplificateur,
une installation (100) est prévue pour modifier périodiquement une amplification prédéfinie ($V_0$) de l'amplificateur d'une première quantité prédéfinie ($\Delta a$) à intervalles de temps prédéfinis pour une période prédéfinie correspondante et
une installation (20, 80) est prévue pour augmenter ou diminuer l'amplification prédéfinie ($V_0$) d'une deuxième quantité prédéfinie en fonction de la modification analysée du niveau des signaux à la sortie de l'amplificateur lors de la modification périodique de l'amplification prédéfinie.

**2.** Montage de circuits selon la revendication 1,
**caractérisé en ce que**
une mémoire enregistrant un intervalle d'oscillation prédéfini de l'amplificateur est reliée au dispositif de contrôle et d'analyse (90) et **en ce que** le dispositif de contrôle et d'analyse peut calculer l'intervalle d'oscillation actuel de l'amplificateur et comparer celui-ci avec l'intervalle d'oscillation enregistré à partir de la modification du niveau des signaux à la sortie de l'amplificateur en fonction de la modification de l'amplification prédéfinie à hauteur de la première quantité prédéfinie.

**3.** Montage de circuits selon la revendication 1 ou 2,
**caractérisé en ce que**
l'installation destinée à la modification périodique comprend un élément d'affaiblissement pour l'abaissement périodique de l'amplification prédéfinie.

**4.** Procédé destiné à la régulation adaptative de l'amplification d'un amplificateur à réaction pour signaux numériques selon l'une des revendications 1 à 3, comprenant les étapes de procédé suivantes :

- préréglage de l'amplification ($V_0$) de l'amplificateur ;
- modification périodique de l'amplification préréglée ($V_0$) d'une première quantité prédéfinie ($\Delta a$) ;
- contrôle et analyse d'une modification du niveau de signaux à la sortie de l'amplificateur pendant la modification périodique de l'amplification préréglée ; et
- augmentation ou diminution de l'amplification préréglée ($V_0$) d'une deuxième quantité prédéfinie en fonction de la modification analysée du niveau de signaux à la sortie de l'amplificateur pendant la modification périodique de l'amplification prédéfinie.

**5.** Procédé selon la revendication 4
**caractérisé en ce que**
l'étape de contrôle et d'analyse comprend les autres étapes de procédé suivantes :

- à partir de la modification du niveau de signaux à la sortie de l'amplificateur est calculée la modification d'amplification correspondante (V) de l'amplificateur à réaction ;

- calcul de l'intervalle d'oscillation actuel de l'amplificateur à partir de la modification de l'amplification ($\Delta V$) et de la modification périodique de l'amplification préréglée ($V_0$) d'une première quantité prédéfinie ;
- comparaison de l'intervalle d'oscillation actuel avec un intervalle d'oscillation prédéfini.

6. Procédé selon la revendication 4 ou 5 **caractérisé en ce que** l'amplification préréglée ($V_0$) est diminuée périodiquement d'une première quantité prédéfinie.

Fig. 1

EP 1 056 198 B1

Fig. 2